# DEMANDE DE BREVET EUROPEEN

(11) **EP 4 761 556 A1**
(43) Date de publication de la demande: **17.06.2026**
(21) Numéro de dépôt: 25221975.3
(22) Date de dépôt: 09.12.2025
(51) Int. Cl.: H10P 72/30, H10P 72/10

(54) **RECEPTACLE POUR PLAQUETTES DE DISPOSITIF(S) MICROELECTRONIQUE(S), ENSEMBLE ET INSTALLATION COMPORTANT UN TEL RECEPTACLE**

(30) Priorité: 10.12.2024 FR 2413725
(71) Demandeur: COMMISSARIAT À L'ÉNERGIE ATOMIQUE ET AUX ÉNERGIES ALTERNATIVES, 75015 Paris (FR); 3SUN S.r.l, 95121 Catania (IT)
(72) Inventeur: JERONIMO, Pedro, 38054 GRENOBLE Cedex 09 (FR); BARTH, Vincent, 38054 GRENOBLE Cedex 09 (FR); NICOTRA, Domenico, 95121 CATANIA (IT)
(74) Mandataire: Santarelli

(57) **Abrégé**

L'invention concerne un réceptacle pour accueillir un empilement de plaquettes de dispositif(s) microélectronique(s) ou de cellule(s) solaire(s), comportant un support de fond (22) sur lequel une ou plusieurs plaquettes sont destinées à être empilées et un ou plusieurs montants (23, 24) reliés audit support de fond (22), lesdits un ou plusieurs montants (23, 24) s'étendant selon une première direction sensiblement perpendiculaire à un plan principal du support de fond (22) et étant répartis en périphérie du support de fond (22) pour délimiter une zone de réception des plaquettes et guider les plaquettes. Un montant donné parmi lesdits montants du réceptacle comporte un conduit de gaz (45, 46) apte à être raccordé à une source d'alimentation en gaz, en particulier de l'air sous pression, et une buse de soufflage (31, 32, 34) configurée pour diriger un flux de gaz émanant dudit conduit vers la zone de réception.

## Description

### DOMAINE TECHNIQUE DE L'INVENTION

L'invention se rapporte au domaine de la fabrication de dispositifs microélectroniques ou de cellules solaires, aussi appelées cellules photovoltaïques, obtenus à partir d'une ou plusieurs plaquettes, telles que des plaquettes en matériau semi-conducteur.

En particulier, l'invention concerne un réceptacle pour accueillir un empilement de plaquettes de dispositifs microélectronique(s) ou de cellule(s) solaire(s), un ensemble formé d'un tel réceptacle et d'une ou plusieurs plaquettes empilées, ainsi qu'une installation comprenant un équipement de production et un tel réceptacle.

### ÉTAT DE LA TECHNIQUE

Les cellules photovoltaïques sont typiquement composées de plaquettes, également appelées "wafers", qui peuvent prendre la forme de pavés droits de faible épaisseur. Ces plaquettes sont généralement fabriquées à partir d'un matériau semi-conducteur, par exemple du silicium et notamment du silicium cristallin.

Lors de la fabrication des cellules, un empilement de ces plaquettes est disposé dans un réceptacle, souvent désigné "panier". Ce réceptacle est ensuite placé dans un équipement de production, où il est transporté via un ou plusieurs convoyeurs jusqu'à une zone spécifique de l'équipement de production dans laquelle les plaquettes sont déchargées du réceptacle. Le réceptacle permet donc de transporter plusieurs plaquettes simultanément et de manière sécurisée dans l'équipement de production.

Dans la zone de déchargement, les plaquettes sont extraites une à une grâce à un dispositif de préhension. Le dispositif de préhension, qui utilise généralement une ventouse ou un préhenseur à effet Bernoulli, saisit la plaquette située au sommet de l'empilement de plaquettes. Toutefois, il n'est pas rare que des plaquettes adhèrent les unes aux autres, par exemple par capillarité. Lorsque la plaquette au sommet de l'empilement est saisie par le dispositif de préhension, la ou les plaquettes qui y adhèrent peuvent se détacher, tomber et être endommagées lors du déchargement.

Pour résoudre ce problème, une solution consiste à souffler un gaz, généralement de l'air sous pression, entre les plaquettes pour faciliter leur séparation. Le soufflage est effectué de manière à ce que les plaquettes décollées retombent dans le dispositif de réception sans être endommagées. À cette fin, des buses de soufflage sont installées dans la zone de déchargement de l'équipement de production, au-dessus du réceptacle.

Cependant, bien que cette technique de soufflage permette de séparer efficacement les plaquettes, plusieurs améliorations peuvent encore être apportées, notamment en termes de fiabilité et d'efficacité.

Un des problèmes rencontrés est que la position du réceptacle n'est pas toujours constante dans la zone de déchargement, ce qui oblige à ajuster fréquemment la position des buses pour garantir une séparation efficace des plaquettes. De plus, les buses sont disposées de manière à ne pas entraver le passage du réceptacle, mais ce positionnement, bien que nécessaire pour ne pas entraver le déplacement du réceptacle, ne permet pas une séparation efficace des plaquettes.

Il existe donc un besoin pour assurer une séparation fiable des plaquettes empilées malgré le déplacement du réceptacle dans l'équipement de production et les contraintes de positionnement des buses de soufflage.

### EXPOSÉ DE L'INVENTION

La présente invention vise à remédier à tout ou partie des inconvénients de l'état de la technique cités ci-dessus.

À cet effet, l'invention vise, selon un premier aspect, un réceptacle pour accueillir un empilement de plaquettes de dispositif microélectronique ou de cellule solaire et pour être transporté sur un convoyeur afin de déplacer simultanément lesdites plaquettes empilées, le réceptacle comportant :
- un support de fond sur lequel lesdites plaquettes sont destinées à être empilées, et
- un ou plusieurs montants reliés audit support de fond, lesdits un ou plusieurs montants s'étendant selon une première direction sensiblement perpendiculaire à un plan principal du support de fond et étant répartis en périphérie du support de fond pour délimiter une zone de réception des plaquettes et guider les plaquettes, et

- un dispositif de soufflage qui comporte une buse de soufflage configurée pour diriger un flux de gaz vers la zone de réception pour séparer lesdites plaquettes, le réceptacle étant configuré pour être alimenté en gaz par une source d'alimentation en gaz externe audit réceptacle, ledit réceptacle étant caractérisé en ce que la buse de soufflage est intégrée dans au moins un montant donné parmi lesdits montants, et en ce que le dispositif de soufflage comporte en outre :
- un organe de raccordement par lequel le réceptacle est alimenté en gaz par la source d'alimentation en gaz, et
- un conduit de gaz qui est ménagé dans ledit montant et qui raccorde fluidiquement l'organe de raccordement à ladite buse de soufflage.

Il suffit donc de régler la buse de soufflage dans une position permettant une séparation efficace des plaquettes lors de la première utilisation du réceptacle. En d'autres termes, il est possible de garantir une efficacité élevée de séparation des plaquettes à chaque utilisation du réceptacle, sans qu'il soit nécessaire d'ajuster la position de la buse de soufflage entre chaque utilisation.

Grâce au réceptacle selon l'invention, il est donc possible de garantir une séparation fiable des plaquettes malgré le déplacement du réceptacle dans l'équipement de production et sans se soucier du positionnement de la buse de soufflage.

Des caractéristiques préférées, simples, commodes et économiques de l'ensemble selon l'invention sont présentées ci-après.

Une fente peut être ménagée dans ledit montant donné, ladite fente formant au moins partiellement la buse de soufflage.

La buse de soufflage peut être orientable.

La buse de soufflage est orientable entre au moins une première position dans laquelle le flux de gaz est dirigé en direction du support de fond et au moins une deuxième position dans laquelle le flux de gaz est dirigé orthogonalement au montant donné ou à l'opposé du support de fond.

La buse de soufflage peut comporter une fente ménagée dans le montant donné et un organe de guidage orientable disposé au moins partiellement dans la fente.

Le réceptacle peut comporter un organe de réglage de la buse de soufflage, ledit organe de réglage étant pourvu d'une portion de connexion reliée à l'organe de guidage orientable et d'une portion de manipulation accessible à un utilisateur et reliée à la portion de connexion de sorte que lorsqu'un utilisateur manipule la portion de manipulation, l'organe de guidage orientable est pivoté, modifiant ainsi la direction du flux de gaz.

La buse de soufflage peut être située du côté d'une extrémité libre du montant donné opposée à une autre extrémité du montant reliée au support de fond.

Le montant donné peut être creux, le conduit de gaz s'étendant à l'intérieur dudit montant donné.

Le support de fond peut être sous forme d'un cadre, en particulier rectangulaire ou carré, présentant au moins trois côtés reliés les uns aux autres, et dans lequel le réceptacle comporte autant de montants que le cadre comporte de côtés, chaque côté du cadre étant relié à au moins un montant et chaque montant étant pourvu d'une buse de soufflage.

Le montant donné peut comprendre une première buse de soufflage et une deuxième buse de soufflage distincte de la première buse de soufflage, la première buse de soufflage et la deuxième buse de soufflage étant configurées pour diriger leur flux de gaz respectif dans des directions différentes.

Le réceptacle peut comprendre un montant latéral positionné le long d'un côté du cadre, à distance d'une intersection dudit côté avec des côtés adjacents, et un montant d'angle positionné à l'intersection de deux côtés adjacents du cadre, chacun du montant latéral et du montant d'angle étant pourvu d'une buse de soufflage, la buse de soufflage du montant latéral et la buse de soufflage du montant d'angle étant configurées pour diriger leur flux de gaz respectif dans des directions différentes.

L'organe de raccordement peut comporter un orifice présentant une première extrémité débouchant sur une face externe du support de fond , la face externe étant opposée à la zone de réception des plaquettes , et une deuxième extrémité, opposée à la première extrémité, débouchant dans le conduit de gaz, l'orifice présentant une forme conique dont le diamètre diminue selon une direction allant de la première extrémité à la deuxième extrémité.

L'invention vise aussi, selon un deuxième aspect, un ensemble formé d'un réceptacle tel que décrit conformément au premier aspect de l'invention, d'une ou plusieurs plaquettes empilées selon une direction d'empilement sensiblement perpendiculaire au plan principal du support de fond.

L'invention vise également, selon un troisième aspect, une installation comprenant un équipement de production et un réceptacle tel que décrit précédemment, l'équipement de production comprenant :
- un convoyeur configuré pour déplacer le réceptacle le long d'une trajectoire définie, et
- un organe de raccordement complémentaire configuré pour être raccordé fluidiquement d'une part à la source d'alimentation en gaz et d'autre part à l'organe de raccordement du réceptacle de manière amovible,
l'installation étant configurée de sorte que le convoyeur déplace le réceptacle le long d'une première portion de la trajectoire dans laquelle l'organe de raccordement du réceptacle n'est pas raccordé fluidiquement à l'organe de raccordement complémentaire, jusqu'à une deuxième portion de la trajectoire dans laquelle l'organe de raccordement complémentaire est raccordé fluidiquement à l'organe de raccordement du réceptacle, de sorte à alimenter le réceptacle en gaz.

L'installation pouvant comprendre un espace de passage correspondant à la trajectoire de déplacement du réceptacle dans l'équipement de production, et dans laquelle l'organe de raccordement complémentaire est mobile entre une position déployée dans laquelle il se trouve dans l'espace de passage pour être raccordé fluidiquement à l'organe de raccordement du réceptacle et une position rétractée dans laquelle il se trouve hors de l'espace de passage.

### BRÈVE DESCRIPTION DES FIGURES

D'autres avantages, buts et caractéristiques particulières de la présente invention ressortiront de la description non limitative qui suit d'au moins un mode de réalisation particulier des dispositifs et procédés objets de la présente invention, en regard des dessins annexés.
La figure 1 est une vue schématique partielle d'une installation selon l'invention.
La figure 2 est une vue en perspective d'un réceptacle selon l'invention.
La figure 3 est une vue de détail d'un montant latéral du réceptacle de la figure 2.
La figure 4 est une vue similaire à celle de la figure 3, mais dans laquelle une paroi du montant latéral est représentée en transparence pour montrer l'intérieur du montant latéral.
La figure 5 est une vue similaire à celle de la figure 4, sous un angle différent, et dans laquelle une autre paroi du montant latéral est représentée en transparence pour montrer l'intérieur du montant latéral.
La figure 6 est une vue de détail de la figure 4, montrant un organe de guidage disposé à l'intérieur d'une rainure, dont une paroi est représentée en transparence pour montrer l'organe de guidage.
La figure 7 est une vue similaire à celle de la figure 2, sous un angle de vue différent.
La figure 8 est un schéma-blocs représentant un procédé de déchargement de plaquettes du réceptacle dans l'installation de la figure 1.
La figure 9 est une vue schématique montrant le déplacement du réceptacle sur un équipement de production, entre une position de départ et une position d'arrivée.
La figure 10 est une vue similaire à celle de la figure 8, montrant le réceptacle dans la position d'arrivée.
La figure 11 est une vue schématique montrant différents flux de gaz émanant de différentes buses de soufflage du réceptacle de la figure 2.

### DESCRIPTION DÉTAILLÉE DE L'INVENTION

La présente description est donnée à titre d'exemple de réalisation non limitatif.

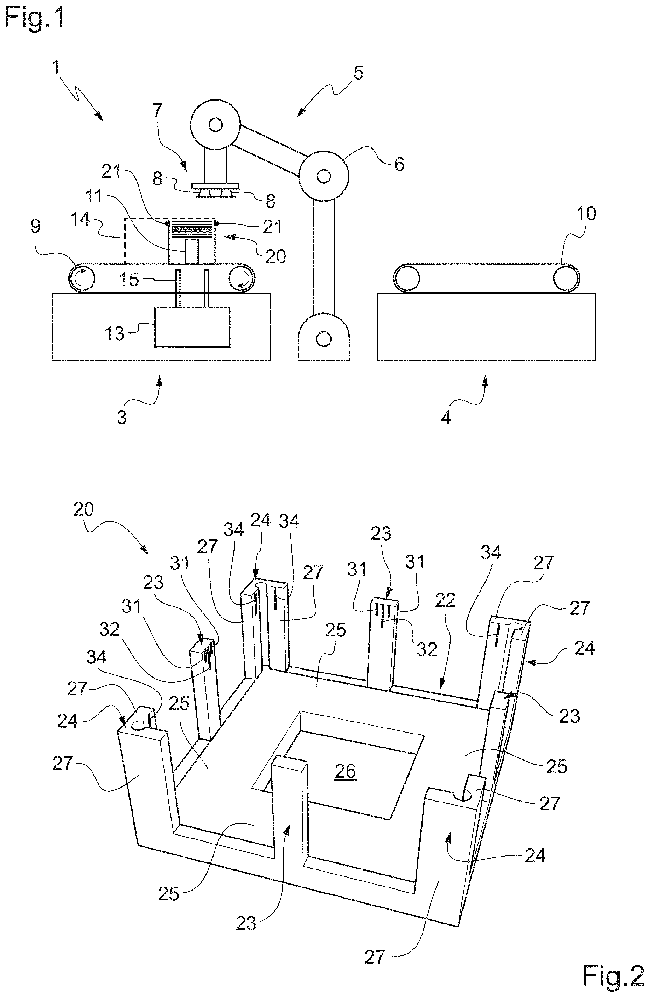

La figure 1 représente une installation 1 pour la fabrication de dispositifs microélectroniques ou de cellules solaires, telles que des cellules photovoltaïques destinées à être utilisées dans des panneaux photovoltaïques.

Les dispositifs microélectroniques ou les cellules solaires sont obtenues à partir d'une ou de plusieurs plaquettes 2, par exemple fabriquées en matériau semi-conducteur, tel que le silicium et notamment le silicium cristallin. Les plaquettes sont également connues sous le nom anglo-saxon de « wafer ».

L'installation 1 comprend ici un premier équipement de production 3 pour déplacer un empilement de plaquettes 2 entre une position de départ et une position d'arrivée et un deuxième équipement de production 4 pour traiter individuellement chaque plaquette 2 de l'empilement.

Le deuxième équipement de production 4 est par exemple configuré pour mettre en œuvre un traitement, tel qu'un dépôt de matériaux, une gravure ou une photolithographie, en vue de la fabrication d'un dispositif microélectronique ou d'une cellule solaire.

Le premier équipement de production 3 comprend un convoyeur 9 configuré pour déplacer l'empilement de plaquettes 2 entre la position de départ et la position d'arrivée le long d'une trajectoire définie.

Le convoyeur 9 est ici configuré pour déplacer l'empilement de plaquettes 2 le long d'une direction sensiblement horizontale, tandis que l'empilement de plaquettes 2 s'étend suivant une direction sensiblement verticale lorsqu'il est déplacé par le convoyeur 9.

Le deuxième équipement de production 4 comprend ici un convoyeur 10 pour déplacer les plaquettes 2 au sein du deuxième équipement de production.

Les convoyeurs 9, 10 sont par exemple des convoyeurs à bandes comprenant deux bandes s'étendant parallèlement et espacées l'une de l'autre. D'autres types de convoyeurs peuvent bien entendu être envisagés.

L'installation 1 comporte en outre un réceptacle 20 pour accueillir l'empilement de plaquettes 2.

Le réceptacle 20 est configuré pour transporter plusieurs plaquettes 2 simultanément au sein du premier équipement de production 3 de manière sécurisée, c'est-à-dire avec un risque limité de chute des plaquettes 2.

Le convoyeur 9 est adapté pour transporter le réceptacle 20 entre la position de départ et la position d'arrivée au sein du premier équipement de production 3.

La trajectoire de déplacement du réceptacle 20 définit un espace de passage 14, représenté en ligne pointillée.

Il est préférable que cet espace de passage ne soit pas encombré afin de faciliter le déplacement du réceptacle 20 de la position de départ jusqu'à la position d'arrivée.

L'installation comporte un dispositif de préhension 5 configuré pour saisir les plaquettes 2 une par une dans le réceptacle 20 et pour les disposer sur le convoyeur 10 du deuxième équipement de production 4, lorsque le réceptacle 20 se trouve dans la position d'arrivée sur le premier équipement de production 3, illustrée à la figure 1.

En particulier, le dispositif de préhension 5 est configuré pour saisir la plaquette 2 qui se trouve au sommet de l'empilement, c'est-à-dire la plus éloignée du convoyeur 9.

Le dispositif de préhension 5 comporte ici un bras robotisé 6 articulé et une tête de préhension 7 portée par le bras robotisé 6.

La tête de préhension 7 comprenant des ventouses 8 pouvant être raccordées à une source de vide.

Pour éviter que la plaquette 2 située sous la plaquette située au sommet de l'empilement n'adhère à cette dernière lorsqu'elle est saisie par le dispositif de préhension 5, le réceptacle 20 comporte des buses de soufflage 21 configurées pour diriger un flux de gaz vers les plaquettes 2, et plus particulièrement entre les plaquettes.

Le premier équipement de production 3 comprend une source d'alimentation en gaz 13 et des organes de raccordement complémentaires 15 raccordés fluidiquement à la source d'alimentation en gaz 13 et configurés pour être raccordés fluidiquement aux buses de soufflage 21, notamment lorsque le réceptacle 20 se trouve dans la position d'arrivée.

Chaque organe de raccordement complémentaire 15 est mobile entre une position déployée pour être raccordé fluidiquement aux buses de soufflage 21 et une position rétractée.

Dans la position déployée, l'organe de raccordement complémentaire 15 se trouve dans l'espace de passage 14 du réceptacle 20, tandis que dans la position rétractée, l'organe de raccordement complémentaire 15 se trouve hors de l'espace de passage 14 pour ne pas entraver le passage du réceptacle 20.

Le premier équipement de production 3 comprend un organe de levage 11 configuré pour déplacer les plaquettes 2 dans le réceptacle 20 à mesure que le nombre de plaquettes de l'empilement diminue, pour maintenir au moins les deux plaquettes situées au sommet de l'empilement en regard du flux de gaz émanant des buses de soufflage.

Le maintien des deux plaquettes situées au sommet de l'empilement face au flux de gaz permet d'assurer leur séparation, notamment lorsqu'elles sont collées par effet de capillarité, en dirigeant le gaz directement sur la zone d'adhérence. Ainsi, seule la plaquette située au sommet de l'empilement est déplacée par le dispositif de préhension 5 et le risque de chute d'autres plaquettes est réduit voire supprimé.

L'organe de levage 11 est mobile entre une position déployée pour lever l'empilement de plaquettes 2 et une position rétractée.

Dans la position déployée, l'organe de levage 11 se trouve dans l'espace de passage 14 du réceptacle 20, tandis que dans la position rétractée, l'organe de levage 11 se trouve hors de l'espace de passage 14 pour ne pas entraver le passage du réceptacle 20.

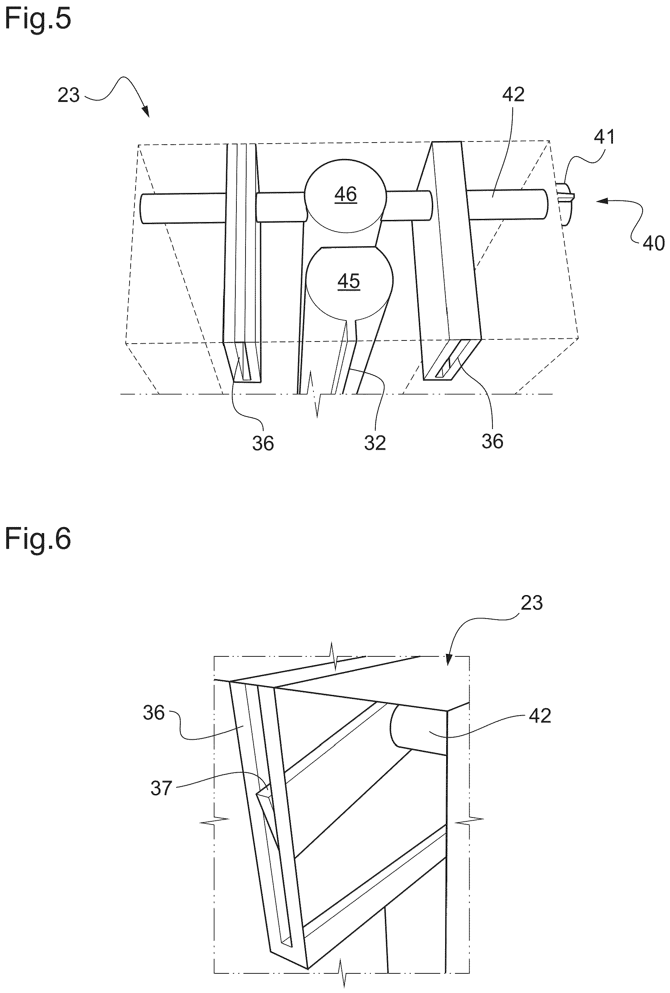

On va maintenir décrire plus en détail un exemple de réceptacle 20 de l'installation 1 en référence aux figures 2 à 7.

En référence à la figure 2, le réceptacle 20 comporte un support de fond 22 sur lequel une ou plusieurs plaquettes sont destinées à être empilées et plusieurs montants 23, 24 reliés au support de fond 22 pour délimiter une zone de réception des plaquettes et guider les plaquettes.

Le support de fond 22 présente une forme de cadre, comportant des côtés 25 définissant entre eux une ouverture 26.

L'ouverture 26 est adaptée pour permettre le passage de l'outil de levage 11 du premier équipement de production 3, tout en empêchant le passage les plaquettes 2.

En d'autres termes, l'ouverture 26 présente des dimensions supérieures aux dimensions de l'outil de levage 11 mais inférieures aux dimensions des plaquettes 22.

Les montants 23, 24 s'étendent selon une première direction sensiblement perpendiculaire à un plan principal du support de fond 22 et sont répartis en périphérie du support de fond 22.

Les montants 23, 24, définissent, du côté d'une extrémité libre opposée à une autre extrémité reliée au support de fond 22, une ouverture pour la réception et l'extraction des plaquettes.

Chaque montant 23, 24 comporte ici plusieurs buses de soufflage 31, 32, 34, configurées pour diriger un flux de gaz vers la zone de réception du réceptacle 20.

Les buses de soufflage 31, 32, 34 sont ainsi maintenues dans une position déterminée par rapport à l'empilement de plaquettes, quelle que soit la position du réceptacle 20 dans le premier équipement de production.

Les buses de soufflage 31, 32, 34 sont ici intégrées dans les montants 23, 24, c'est-à-dire qu'elles font partie des montants.

On notera toutefois que d'autres configurations sont possibles à condition que les buses de soufflage 31, 32, 34 fassent partie du réceptacle 20. Par exemple, les buses de soufflage peuvent être positionnées entre deux montants adjacents, sans y être intégrées.

Dans l'exemple représenté, le support de fond 22 présente une forme de cadre carré et comporte ainsi quatre côtés 25. L'ouverture 26 est également carrée.

La forme du cadre dépend principalement de la forme des plaquettes. Le réceptacle 20 représenté est ainsi particulièrement adapté pour recevoir des plaquettes carrées ou pseudo-carrées.

D'autres formes de cadre peuvent toutefois être envisagées, selon la forme des plaquettes, telles que des formes rectangulaires, circulaires ou triangulaires.

Les montants comprennent des montants latéraux 23, ici au nombre de quatre, positionnés chacun le long d'un côté respectif du cadre et des montants d'angle 24, ici au nombre de quatre, positionnés chacun à une intersection respective de deux côtés adjacents du cadre.

Les buses de soufflage 31, 32, 34 sont situées du côté d'une extrémité libre des montants 23, 24 opposée à une autre extrémité des montants reliée au support de fond 22.

Comme indiqué précédemment, il suffit de diriger un flux de gaz entre les deux plaquettes situées au sommet de l'empilement pour supprimer le risque de chute lors de la saisie de la plaquette située au sommet de l'empilement par le dispositif de préhension 5.

L'agencement des buses de soufflage 31, 32, 34 du côté de l'extrémité libre des montants 23, 24 permet ainsi de maximiser le nombre de plaquettes dans le réceptacle 20, tout en ayant un faible risque de chute due à l'adhésion entre les plaquettes.

Chaque montant d'angle 24 comporte deux panneaux 27 reliés l'un à l'autre, chaque panneau 27 étant aligné le long d'un des côtés du cadre.

Chaque montant latéral 23 comporte ici une buse de soufflage non-orientable 31 et deux buses de soufflage orientables 32.

Les buses de soufflage orientables 32 sont disposées de part et d'autre de la buse de soufflage non-orientable 31.

Chaque montant d'angle 24 comporte ici deux buses de soufflage non-orientables 33, disposées chacune sur un panneau 27 respectif.

A l'inverse des buses de soufflage non-orientables 31, 33, chaque buse de soufflage orientable 32 est configurée pour permettre une modification de la direction du flux de gaz, selon les besoins d'utilisation.

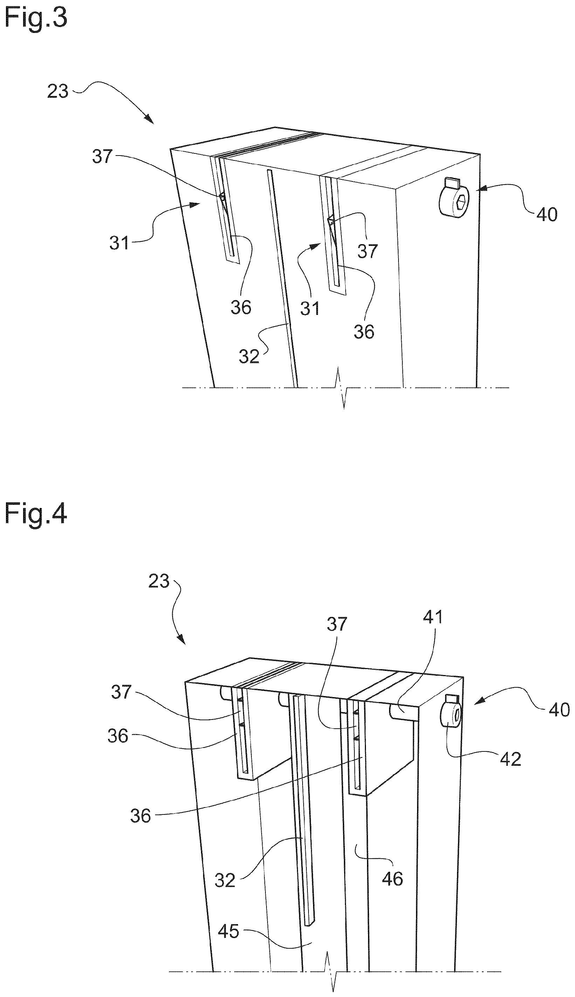

La figure 3 représente l'extrémité libre d'un montant latéral 23 comprenant une première fente 32 et deux deuxièmes fentes 36 disposées de part et d'autre de la première fente 32 selon une direction perpendiculaire à la première direction.

La première fente 32 s'étend principalement selon la première direction.

Ainsi, la première fente 32 est configurée pour générer un flux d'air réparti sur une zone allongée dans la première direction, qui est parallèle à la direction d'empilement des plaquettes.

Cet agencement offre une certaine souplesse pour cibler les deux plaquettes situées au sommet de l'empilement.

En particulier, la première fente 32 présente une dimension, selon cette première direction, qui ne représente qu'une partie de la dimension du montant latéral 23 dans cette première direction, par exemple moins de 50% (entre 0% et 50%), moins de 30% (entre 0% et 30%), voire moins de 20% (entre 0% et 20%) de la dimension du montant latéral 23 dans la première direction.

Le choix d'une dimension de la fente dans la première direction inférieure à 50% de la dimension du montant latéral dans cette première direction représente un compromis intéressant entre la souplesse de répartition du flux de gaz et son intensité.

En effet, cela signifie que les deux plaquettes situées au sommet de l'empilement peuvent se trouver dans une zone s'étendant dans la première direction et pouvant représenter jusqu'à 50% de la dimension du montant latéral dans cette première direction et être séparées de manière fiable.

Les buses de soufflage 34 des montants d'angle 24 sont identiques aux buses de soufflage non-orientables 32 des montants latéraux 23.

Ainsi, les montants d'angle 24 comprennent deux fentes identiques aux premières fentes 32 des montants latéraux 23 et réparties sur les panneaux 27.

Les buses de soufflage orientables 31 comportent chacune une deuxième fente 36 ménagée dans le montant latéral 23 et un organe de guidage orientable 37 disposé au moins partiellement dans la deuxième fente 36.

La deuxième fente 36 s'étend principalement selon la première direction.

L'organe de guidage orientable 37 est monté libre en rotation dans la deuxième fente 36 autour d'un axe sensiblement orthogonal à la première direction de sorte à pouvoir être déplacé le long de la première direction.

Ainsi, l'organe de guidage 37 est configuré pour diriger un flux d'air dans une zone allongée dans la première direction, qui est parallèle à la direction d'empilement des plaquettes.

Le montant latéral 23 comporte un organe de réglage 40 pour modifier manuellement la direction du flux de gaz des buses de soufflage 31 orientables.

L'organe de réglage 40 comporte une portion de manipulation 41 qui est directement accessible à un utilisateur du réceptacle, c'est-à-dire qu'il n'est pas nécessaire de démonter le réceptacle pour y accéder.

En particulier, la portion de manipulation 41 de l'organe de réglage 40 est ici disposée en saillie d'une face du montant latéral 23 pour faciliter son repérage et son utilisation.

La portion de manipulation 41 est raccordée mécaniquement à l'organe de guidage orientable 37.

L'organe de réglage 40 est ainsi configuré de sorte que lorsque l'utilisateur manipule la portion de manipulation, l'organe de guidage orientable 37 est pivoté, changeant ainsi la direction du flux de gaz.

Ici, l'organe de réglage 40 est configuré pour agir simultanément sur la direction du flux de gaz de chaque buse de soufflage orientable 32. Dans une variante non représentée, le montant latéral comporte autant d'organes de réglage que de buses de soufflage orientables et chaque organe de réglage est configuré pour agir sur la direction du flux de gaz d'une buse de soufflage orientable respective.

Comme visible sur les figures 4 à 6, le réceptacle 20 comporte un premier conduit de gaz 45 adapté à être raccordé à la source d'alimentation en gaz.

Le premier conduit de gaz 45 est raccordé fluidiquement à la première fente 32, de sorte que le gaz émanant du premier conduit de gaz 45 est dirigé vers la zone de réception à travers la première fente 32.

La première fente 32 communique directement avec le premier conduit de gaz 45, c'est-à-dire sans l'intermédiaire d'un conduit ou autre.

Le réceptacle 20 comporte en outre un deuxième conduit de gaz 46, distinct du premier conduit de gaz 45, apte à être raccordé à la source d'alimentation en gaz.

Ici, l'organe de guidage 37 est un canal, notamment de section rectangulaire.

L'organe de réglage 40 comporte en outre une portion de connexion 42 raccordant mécaniquement la portion de manipulation 41 à chaque canal 37, de sorte que lorsqu'un utilisateur manipule la portion de manipulation 41, les organes de guidage 47 sont déplacés par l'intermédiaire de la portion de connexion 42.

La portion de connexion 42 raccorde fluidiquement le deuxième conduit de gaz 46 au canal 37 de chaque buse de soufflage orientable 31.

Ainsi, le gaz émanant du deuxième conduit de gaz 47 est dirigé vers le canal 37 de chaque buse de soufflage orientable 31 par l'intermédiaire de la portion de connexion 42 de l'organe de réglage 40.

Ici, la portion de connexion 42 traverse le deuxième conduit de gaz 46 et comporte une ouverture (non visible) débouchant à l'intérieur du deuxième conduit de gaz pour recevoir le gaz et le guider jusqu'aux canaux 37.

Grâce à cet agencement, la portion de connexion 42 est configurée pour raccorder fluidiquement le deuxième conduit de gaz 46 aux canaux 37, tout en pouvant être pivotée par rapport au deuxième conduit de gaz 46.

Grâce à la capacité de déplacement des canaux 37 à l'intérieur des deuxièmes rainures 31, chaque deuxième buse de soufflage 31 est orientable selon la première direction entre au moins une première position dans laquelle le flux de gaz est dirigé en direction du support de fond et au moins une deuxième position dans laquelle le flux de gaz est dirigé à l'opposé du support de fond ou orthogonalement au montant latéral 23.

En d'autres termes, le flux de gaz comprend dans la première position au moins une composante orientée vers le support de fond, tandis qu'il comprend dans la deuxième direction au moins une composante orientée à l'opposé du support de fond ou aucune composante vers le support de fond ou à l'opposé du support de fond.

Dans l'exemple représenté, le montant latéral 23 est creux, c'est-à-dire qu'il est formé par des parois définissant entre elles une cavité.

Le premier conduit de gaz 45 et le deuxième conduit de gaz 46 s'étendent à l'intérieur du montant latéral 23.

Les conduits de gaz 45, 46 sont ainsi protégés et ne risquent pas d'être accrochés par des éléments du premier équipement de production.

La portion de connexion 42 de l'organe de réglage 40 est également disposée à l'intérieur du montant latéral 23, tandis que la portion de préhension 41 est disposée à l'extérieur du montant latéral.

On notera que dans l'exemple représenté, tous les montants latéraux 23 sont identiques.

Les montants d'angle 24 sont également creux et comprennent, à l'intérieur des montants, des conduits de gaz apte à être raccordés fluidiquement à la source d'alimentation en gaz et étant raccordés fluidiquement aux fentes.

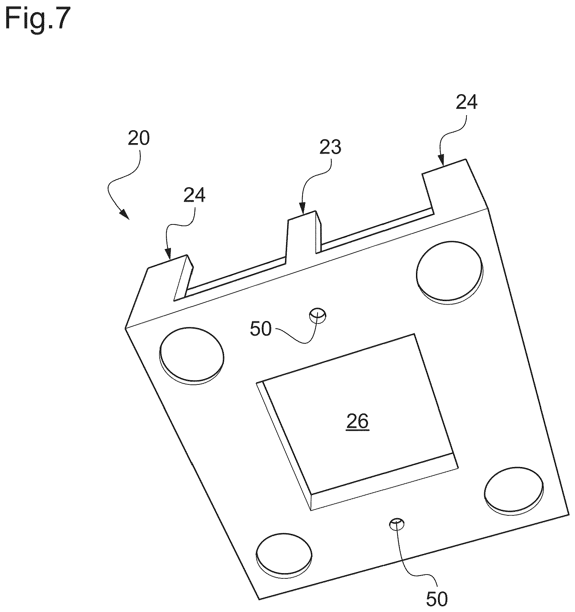

Comme visible sur la figure 7, le réceptacle 20 comporte des organes de raccordement 50, ici au nombre de deux, pour le raccordement des premier et deuxième conduits de gaz 45, 46 à la source d'alimentation en gaz.

Les organes de raccordement 50 sont disposés de part et d'autre de l'ouverture 26 du cadre.

Chaque organe de raccordement comporte ici un orifice 50 ayant une première extrémité débouchant sur une face externe du support de fond 22, la face externe étant opposée à la zone de réception des plaquettes, et une deuxième extrémité opposée à la première extrémité, débouchant dans le premier conduit de gaz 45 et/ou le deuxième conduit de gaz 46.

Chaque orifice 50 présente ici une forme conique dont le diamètre diminue selon une direction allant de la première extrémité à la deuxième extrémité.

Chaque orifice peut être relié à un ou plusieurs conduits.

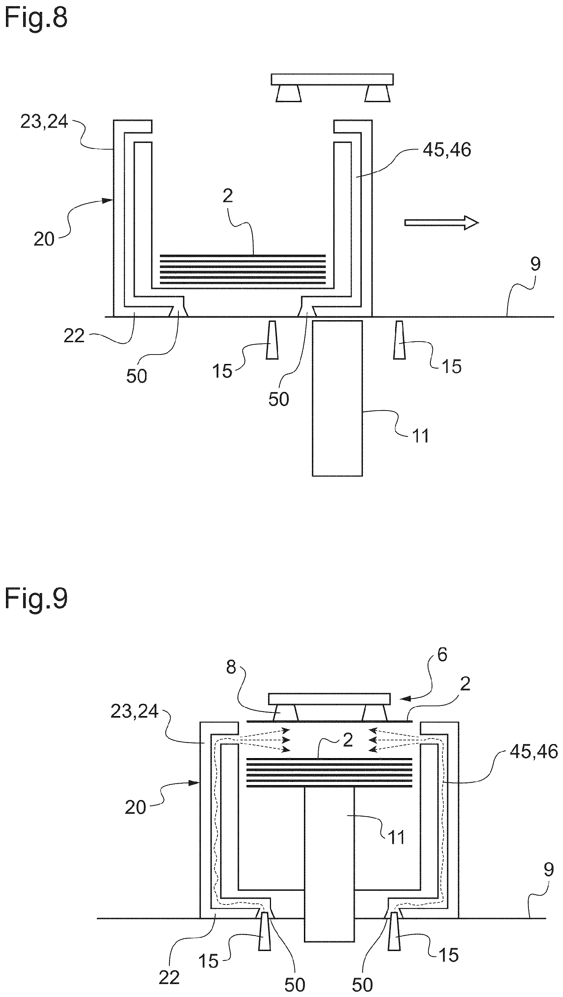

On va maintenant décrire, en référence aux figures 8 à 10, un procédé de déchargement 100 d'une plaquette reçue dans le réceptacle 20, mis en œuvre par l'installation de la figure 1.

Le procédé de déchargement 100 comporte au préalable une étape de fourniture d'un ensemble comportant le réceptacle 20 et une ou plusieurs plaquettes 2 empilées reçues dans la zone de réception du réceptacle, et une étape de positionnement de cet ensemble sur le convoyeur 9 du premier équipement de production 3, dans une position de départ, comme cela est représenté à la figure 9.

En particulier, l'empilement de plaquettes repose sur le support de fond 22 du réceptacle 20 et est ainsi transporté de manière sécurisé au sein du premier équipement de production 3.

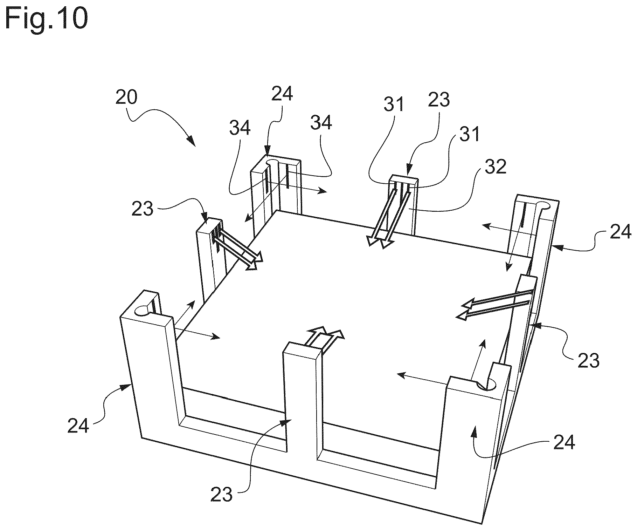

Le procédé de déchargement 100 comporte une étape de déplacement 101 de l'ensemble, formé par le réceptacle 20 et les plaquettes 2, par le convoyeur 9 jusqu'à une position d'arrivée, représentée à la figure 10.

Pour ne pas gêner le déplacement du réceptacle 20 entre sa position de départ et sa position d'arrivée au sein du premier équipement de production, l'organe de levage 11 se trouve dans sa position rétractée.

Dans cette position, l'organe de levage 11 se trouve hors de l'espace de passage 14 du réceptacle 20.

Lorsque le réceptacle 20 se trouve dans la position d'arrivée (figure 10), l'organe de levage 11 est disposé en regard de l'ouverture 26 et les organes de raccordement complémentaires sont disposés en regard des orifices 50.

Le procédé de déchargement 100 comporte une étape de levage 101 de l'empilement de plaquettes. Cette étape est mise en œuvre lorsque les plaquettes situées au sommet de l'empilement ne se trouvent pas (ou plus) au niveau du flux d'air émanant des buses de soufflage.

L'étape de levage 11 comporte le déplacement de l'organe de levage 11, à travers l'ouverture 26 du réceptacle 20, d'une position rétractée vers une position déployée pour maintenir les deux plaquettes situées au sommet de l'empilement en regard d'un flux de gaz émanant des buses de soufflage 21.

Le procédé de déchargement 100 comporte en outre une étape de raccordement fluidique 102 , de manière amovible, du réceptacle 20 à la source d'alimentation en gaz.

L'étape de raccordement fluidique 102 comporte le déplacement des organes de raccordement complémentaire 15 de leur position rétractée vers leur position déployée pour être chacun inséré dans un orifice 50 correspondant du réceptacle 20, et ainsi raccorder fluidiquement, de manière amovible, la source d'alimentation en gaz aux buses de soufflage 31, 32, 34.

La forme conique des orifices 50 permet de faciliter l'insertion des organes de raccordement complémentaires 15 du premier équipement de production 3 dans les orifices 50 du réceptacle 20, notamment lorsque le réceptacle n'est pas parfaitement positionné.

Le procédé de déchargement 100 comporte en outre une première étape d'activation 103 du soufflage par les buses de soufflage 31, 32, 34.

Comme le représentent les flèches en pointillés sur la figure 9, le gaz émanant des organes de raccordement complémentaires 15 passe successivement dans l'orifice 50, le conduit de gaz 45, 46, puis dans la buse de soufflage 21 avant d'être dirigé vers la zone de réception du réceptacle 20 où est disposé l'empilement de plaquettes 2.

La première étape d'activation 103 peut comporter uniquement l'activation des buses de soufflage non orientables 32.

Le procédé de déchargement 100 comporte en outre une étape de saisie 104 de la plaquette 2 située au sommet de l'empilement de plaquettes par le dispositif de préhension 105.

L'étape de saisie comporte l'approche de la tête de préhension 7 de la plaquette située au sommet de l'empilement de plaquettes et l'activation de l'aspiration avec les ventouses 8.

Le procédé de déchargement 100 comporte en outre une étape de descente 105 de l'empilement de plaquettes.

L'étape de descente 105 comporte le déplacement de l'organe de levage 11, à travers l'ouverture 26 du réceptacle 20, d'une position déployée vers une position rétractée.

Le procédé de déchargement 100 comporte en outre une deuxième étape d'activation 106 du soufflage par les buses de soufflage 31, 32, 34.

La deuxième étape d'activation 106 peut comporter uniquement l'activation des buses de soufflage orientables 31, les buses de soufflage orientables 31 étant de préférence orientées vers le support de fond 22.

Le procédé de déchargement 100 comporte ensuite une étape d'éloignement 107 du dispositif de préhension 105, notamment en vue de déposer la plaquette sur le convoyeur 10 du deuxième équipement de production 4.

Lorsque toutes les plaquettes 2 de l'empilement ont été déchargées du réceptacle, l'organe de levage 11 et l'organe de raccordement complémentaire 14 sont déplacés vers leur position rétractée et le réceptacle 20 est évacué du premier équipement de production 3.

La figure 11 illustre le réceptacle 20 dans lequel les buses de soufflages sont configurées pour diriger le flux de gaz selon une configuration prédéfinie.

La buse de soufflage non-orientable 32 et les buses de soufflage orientables 31 de chaque montant latéral 23 sont configurées pour diriger le flux de gaz dans des directions différentes.

En particulier, la buse de soufflage non-orientable 32 de chaque montant latéral 23 est configurée pour diriger le flux de gaz selon une direction sensiblement orthogonal audit montant latéral 23, tandis que les buses de soufflage orientables 33 de chaque montant latéral 23 sont configurées pour diriger le flux de gaz en direction du support de fond 22.

La buse de soufflage 32 de chaque montant latéral 23 et les buses de soufflage de chaque montant d'angle 27 sont configurées pour diriger le flux de gaz dans des directions différentes.

En particulier, la buse de soufflage non-orientable 34 de chaque panneau 27 de chaque montant d'angle 24 est configurée pour diriger le flux de gaz selon une direction sensiblement orthogonal audit montant d'angle 24 et sensiblement orthogonal au flux de gaz émanant de la buse de soufflage non-orientable 23 du montant latéral 23 disposée sur le même côté du cadre le long duquel s'étend ledit panneau 27.

Les conduits de gaz 45, 46 et les buses de soufflage 21, 31, 32, 34 font partie du réceptacle 20 et sont disposés au niveau des montants 23, 24. Chaque buse de soufflage 21, 31, 32, 34 peut donc être maintenue dans une position déterminée par rapport à l'empilement de plaquettes 2, quelle que soit la position du réceptacle 20 dans le premier équipement de production 3.

Il suffit donc de régler les buses de soufflage 21, 31, 32, 34 dans une position permettant une séparation efficace des plaquettes 2 lors de la première utilisation du réceptacle 20. En d'autres termes, il est possible de garantir une efficacité élevée de séparation des plaquettes 2 à chaque utilisation du réceptacle 20, sans qu'il soit nécessaire d'ajuster la position des buses de soufflage 21, 31, 32, 34 entre chaque utilisation.

Grâce au réceptacle 20 selon l'invention, il est donc possible de garantir une séparation fiable des plaquettes 2 malgré le déplacement du réceptacle 20 dans le premier équipement de production 3 et sans se soucier du positionnement des buse de soufflage 21, 31, 32, 34.

Des variantes non illustrées sont décrites ci-dessous.

Le réceptacle peut comporter un seul montant s'étendant en périphérie du support de fond.

Le réceptacle peut être dépourvu de montants d'angle et ne comporter que des montants latéraux.

Inversement, le réceptacle peut être dépourvu de montants latéraux et ne comporter que des montants d'angle.

Chaque montant peut comporter un nombre différent de buses de soufflage, par exemple une seule buse, ou plus de deux.

Chaque montant peut comporter uniquement une ou plusieurs buses non orientables ou uniquement une ou plusieurs buses orientables.

Le montant peut être dépourvu d'organe de réglage.

Les buses et/ou les conduits de gaz peuvent ne pas être intégrées dans les montants, et par exemple être disposées à l'extérieur des montants.

L'organe de guidage peut être formé, non pas par un canal, mais pas une lame montée à rotation dans la fente. Le deuxième conduit de gaz étant alors raccordé fluidiquement, non pas au canal, mais à la fente, par exemple par l'intermédiaire de la portion de connexion de l'organe de réglage.

## Revendications

1. Réceptacle configuré pour accueillir un empilement de plaquettes (2) de dispositif(s) microélectronique(s) ou de cellule(s) solaire(s) et pour être transporté sur un convoyeur (9) afin de déplacer simultanément lesdites plaquettes (2) empilées, le réceptacle comportant :
- un support de fond (22) sur lequel lesdites plaquettes (2) sont destinées à être empilées, et
- un ou plusieurs montants (23, 24) reliés audit support de fond (22), lesdits un ou plusieurs montants (23, 24) s'étendant selon une première direction sensiblement perpendiculaire à un plan principal du support de fond (22) et étant répartis en périphérie du support de fond (22) pour délimiter une zone de réception des plaquettes (2) et guider les plaquettes (2), et
- un dispositif de soufflage qui comporte une buse de soufflage (21, 31, 32, 34) configurée pour diriger un flux de gaz vers la zone de réception pour séparer lesdites plaquettes (2), le réceptacle étant configuré pour être alimenté en gaz par une source d'alimentation en gaz externe audit réceptacle,
ledit réceptacle étant **caractérisé en ce que** la buse de soufflage (21, 31, 32, 34) est intégrée dans au moins un montant donné parmi lesdits montants (23, 24),
et **en ce que** le dispositif de soufflage comporte en outre :
- un organe de raccordement (50) par lequel le réceptacle est alimenté en gaz par la source d'alimentation en gaz, et
- un conduit de gaz (45, 46) qui est ménagé dans ledit montant (23, 24) et qui raccorde fluidiquement l'organe de raccordement (50) à ladite buse de soufflage (21, 31, 32, 34).

2. Réceptacle selon la revendication 1, dans lequel une fente (32, 36) est ménagée dans ledit montant donné, ladite fente (32) formant au moins partiellement la buse de soufflage (21, 31, 32, 34).

3. Réceptacle selon la revendication 1 ou 2, dans lequel la buse de soufflage (21, 31) est orientable.

4. Réceptacle selon la revendication 3, dans lequel la buse de soufflage (21, 31) est orientable entre au moins une première position dans laquelle le flux de gaz est dirigé en direction du support de fond (22) et au moins une deuxième position dans laquelle le flux de gaz est dirigé orthogonalement au montant donné ou à l'opposé du support de fond (22).

5. Réceptacle selon l'une quelconque des revendications 1 à 4, dans lequel la buse de soufflage (21, 31, 32, 34) comporte une fente (36) ménagée dans le montant donné et un organe de guidage (37) orientable disposé au moins partiellement dans la fente (36).

6. Réceptacle selon la revendication 5, comportant un organe de réglage (40) de la buse de soufflage (21, 31), ledit organe de réglage (40) étant pourvu d'une portion de connexion (42) reliée à l'organe de guidage orientable (37) et d'une portion de manipulation (41) accessible à un utilisateur et reliée à la portion de connexion (42) de sorte que lorsqu'un utilisateur manipule la portion de manipulation (42), l'organe de guidage (37) orientable est pivoté, modifiant ainsi la direction du flux de gaz.

7. Réceptacle selon l'une quelconque des revendications 1 à 6, dans lequel la buse de soufflage (21, 31, 32, 34) est située du côté d'une extrémité libre du montant donné opposée à une autre extrémité du montant reliée au support de fond (22).

8. Réceptacle selon l'une quelconque des revendications 1 à 7, dans lequel ledit montant donné est creux, le conduit de gaz (45, 46) s'étendant à l'intérieur dudit montant donné.

9. Réceptacle selon l'une quelconque des revendications 1 à 8, dans lequel le support de fond (22) est sous forme d'un cadre, en particulier rectangulaire ou carré, présentant au moins trois côtés (25) reliés les uns aux autres, et dans lequel le réceptacle comporte autant de montants (23, 24) que le cadre comporte de côtés (25), chaque côté (25) du cadre étant relié à au moins un montant (23, 24) et chaque montant (23, 24) étant pourvu d'une buse de soufflage (21, 31, 32, 34).

10. Réceptacle selon l'une quelconque des revendications 1 à 9, dans lequel ledit montant donné comprend une première buse de soufflage (21, 31, 32, 34) et une deuxième buse de soufflage (21, 31, 32, 34) distincte de la première buse de soufflage, la première buse de soufflage (21, 31, 32, 34) et la deuxième buse de soufflage (21, 31, 32, 34) étant configurées pour diriger leur flux de gaz respectif dans des directions différentes.

11. Réceptacle selon l'une quelconque des revendications 1 à 10, comprenant un montant latéral (23) positionné le long d'un côté (25) du cadre, à distance d'une intersection dudit côté (25) avec des côtés adjacents, et un montant d'angle (24) positionné à l'intersection de deux côtés (25) adjacents du cadre, chacun du montant latéral (23) et du montant d'angle (24) étant pourvu d'une buse de soufflage (21, 31, 32, 34), la buse de soufflage (21, 31, 32) du montant latéral (23) et la buse de soufflage (21, 34) du montant d'angle (24) étant configurées pour diriger leur flux de gaz respectif dans des directions différentes.

12. Réceptacle selon l'une quelconque des revendications 1 à 11, **caractérisé en ce que** l'organe de raccordement (50) comporte un orifice présentant une première extrémité débouchant sur une face externe du support de fond (22), la face externe étant opposée à la zone de réception des plaquettes (2), et une deuxième extrémité, opposée à la première extrémité, débouchant dans le conduit de gaz (45, 46), l'orifice présentant une forme conique dont le diamètre diminue selon une direction allant de la première extrémité à la deuxième extrémité.

13. Ensemble formé d'un réceptacle selon l'une quelconque des revendications 1 à 12, d'une ou plusieurs plaquettes (2) empilées selon une direction d'empilement sensiblement perpendiculaire au plan principal du support de fond (22).

14. Installation comprenant un équipement de production (3) et un réceptacle (20) selon l'une quelconque des revendications 1 à 12, l'équipement de production (3) comprenant :
- un convoyeur (9) configuré pour déplacer le réceptacle (20) le long d'une trajectoire définie, et
- un organe de raccordement complémentaire (15) configuré pour être raccordé fluidiquement d'une part à la source d'alimentation en gaz (13) et d'autre part à l'organe de raccordement (50) du réceptacle (20) de manière amovible,
l'installation étant configurée de sorte que le convoyeur (9) déplace le réceptacle (20) le long d'une première portion de la trajectoire dans laquelle l'organe de raccordement (50) du réceptacle (20) n'est pas raccordé fluidiquement à l'organe de raccordement complémentaire (15), jusqu'à une deuxième portion de la trajectoire dans laquelle l'organe de raccordement complémentaire (15) est raccordé fluidiquement à l'organe de raccordement (50) du réceptacle (20), de sorte à alimenter le réceptacle (20) en gaz.

15. Installation selon la revendication 14, comprenant un espace de passage (14) correspondant à la trajectoire de déplacement du réceptacle (20) dans l'équipement de production (3), et dans laquelle l'organe de raccordement complémentaire (15) est mobile entre une position déployée dans laquelle il se trouve dans l'espace de passage pour être raccordé fluidiquement à l'organe de raccordement (50) du réceptacle (20) et une position rétractée dans laquelle il se trouve hors de l'espace de passage (14).
